(19) Europäisches Patentamt
European Patent Office
Office européen des brevets

(11) **EP 3 309 918 A1**

(12) **EUROPÄISCHE PATENTANMELDUNG**

(43) Veröffentlichungstag:
   18.04.2018   Patentblatt 2018/16

(51) Int Cl.:
   *H02H 3/33* (2006.01)          *G01R 31/327* (2006.01)
   *H02H 1/00* (2006.01)

(21) Anmeldenummer: **17181338.9**

(22) Anmeldetag: **14.07.2017**

(84) Benannte Vertragsstaaten:
   **AL AT BE BG CH CY CZ DE DK EE ES FI FR GB
   GR HR HU IE IS IT LI LT LU LV MC MK MT NL NO
   PL PT RO RS SE SI SK SM TR**
   Benannte Erstreckungsstaaten:
   **BA ME**
   Benannte Validierungsstaaten:
   **MA MD**

(30) Priorität: **30.09.2016   DE 102016218960**

(71) Anmelder: **Siemens Aktiengesellschaft
   80333 München (DE)**

(72) Erfinder: **Martel, Jean-Mary
   93105 Tegernheim (DE)**

(54) **SCHALTER**

(57)     Die Erfindung betrifft einen Schalter zum Schutz eines elektrischen Stromkreises:
- mit einer Auslöseeinrichtung (AE) zur Unterbrechung des elektrischen Stromkreises,
- mit einem Summenstromwandler (ZCT), durch den Leiter des elektrischen Stromkreises zur Ermittlung von Differenzströmen geführt sind und der eine erste Wicklung aufweist, an der ein Differenzstrom abnehmbar ist,
- mit einem Stromsensor (Shunt) zur Ermittlung von Stromwerten des elektrischen Stromkreises,
- mit einem Spannungssensor zur Ermittlung von Spannungswerten des elektrischen Stromkreises,
- mit einer Testtaste (T),
- mit einer Fehlerlichtbogensimulationseinheit (ATSG), die einen Eingang und zwei Ausgänge aufweist,
- mit einem Mikroprozessor (MCU), der mit der Testtaste, dem Stromsensor, dem Spannungssensor, der ersten Wicklung des Summenstromwandler, dem Eingang der Fehlerlichtbogensimulationseinheit und der Auslöseeinrichtung verbunden ist, und derart ausgestaltet ist, dass bei Überschreitung bestimmter Stromgrenzwerte oder bei Vorliegen eines Fehlerlichtbogens eine Unterbrechung des elektrischen Stromkreises durch die Auslöseeinrichtung erfolgt,
wobei der Summenstromwandler eine zweite Wicklung (NT) aufweist, die direkt oder über einen ersten Widerstand (RT) mit dem Mikroprozessor verbunden ist,
wobei die Signale der Ausgänge der Fehlerlichtbogensimulationseinheit an Stelle der Strom- oder/und Spannungswerte dem Mikroprozessor durch ein Testsignal zuführbar sind.

**EP 3 309 918 A1**

**Beschreibung**

Die Erfindung betrifft einen Schalter zum Schutz eines elektrischen Stromkreises.

Mit elektrischem Stromkreis ist insbesondere ein Niederspannungsstromkreis bzw. -netz gemeint. Mit Niederspannung sind Spannungen von bis zu 1000 Volt Wechselspannung oder bis zu 1500 Volt Gleichspannung gemeint.

Mit Schalter ist insbesondere ein Leitungsschutzschalter, wie ein Miniatur Circuit Breaker, Fehlerstromschutzschalter bzw. Residual Current Breaker, Brandschutzschalter bzw. Arc Fault Detection Device, oder ähnlich gemeint. Mit Schalter ist auch ein Leistungsschalter, wie ein Kompaktleistungsschalter bzw. Moulded Case Circuit Breaker, Luftleistungsschalter bzw. Air Circuit Breaker, oder ähnlich gemeint.

Mit Leitungsschutzschalter sind üblicherweise Niederspannungs-Leitungsschutzschalter für Ströme bis zu 125 Ampere, spezifischer bis zu 63 Ampere gemeint.

Leitungsschutzschalter schützen den Stromkreis vor Überströmen und Kurzschlüssen. D.h. überschreitet der Strom im elektrischen Stromkreis einen Stromgrenzwert, kann eine Unterbrechung des elektrischen Stromkreises erfolgen.

Fehlerstromschutzschalter, kurz FI-Schalter, sind allgemein bekannt. Üblicherweise werden hier so genannte Summenstromwandler verwendet. Dabei sind zwei oder mehr Leiter, meist Hin- und Rückleiter bzw. Außen- und Neutralleiter in einem Einphasen-Wechselstromnetz oder alle drei Außenleiter und der Neutralleiter bei einem Dreiphasenwechselstromnetz, durch einen Summenstromwandler geführt. Gewandelt wird dann nur der Differenzstrom, d.h. ein von Hin- und Rückstrom abweichender Strom, aus den Leitern. Üblicherweise ist die Stromsumme bzw. der Differenzstrom in einem elektrischen Stromkreis gleich null. Ist diese ungleich Null, kommen diese durch Fehlerströme zustande, die so erkannt werden können. Überschreiten diese einen Differenzstromgrenzwert, kann eine Unterbrechung des elektrischen Stromkreises erfolgen.

Die Funktionsfähigkeit eines Fehlerstromschutzschalters bzw. einer Fehlerstrom-Schutzeinrichtung lässt sich über eine Prüftaste kontrollieren. Hierzu ist eine Serienschaltung eine Prüftaste mit einem Widerstand, wobei die Serienschaltung einerseits vor dem Summenstromwandler mit einem Leiter und andererseits nach dem Summenstromwandler mit einem anderen Leiter verbunden ist, vorgesehen.

Brandschutzschalter sind relativ neuartige Schutzeinrichtungen für Stromkreise bzw. Spannungsnetze und dienen zum Erkennen von Fehlerlichtbögen, wie parallele oder serielle Lichtbögen. Solche Fehlerlichtbögen, manchmal auch als Störlichtbögen bezeichnet, können durch schlecht geklemmte elektrische Verbindungen in Verteilerdosen oder Steckdosen bzw. durch schlechte Isolierungen und Kontakte entstehen. Brandschutzschalter können insbesondere in Hausinstallationseinrichtungen, wie Sicherungskästen, eingesetzt werden, um derartige Fehler zu erkennen und bei vorliegen eines Fehlers den elektrischen Stromkreis zu unterbrechen.

Mit Fehlerlichtbögen sind insbesondere Lichtbögen gemeint, sowohl serielle als auch parallele, die durch Fehler im Stromkreis entstehen. Lichtbögen, die regulär beim Schalten bzw. durch den Betrieb von gewünschten elektrischen Verbrauchern entstehen, sind hier nicht gemeint.

Brandschutzschalter verwenden verschiedene Prinzipien zur Ermittlung von Fehlerlichtbögen. Ein Prinzip ist die Messung des Frequenzspektrums in einem elektrischen Stromkreis, d.h. auf der elektrischen Leitung. Hierbei werden beispielsweise die hochfrequenten Signale bzw. Signalanteile im Stromkreis/auf der elektrischen Leitung ermittelt.

Zur Ermittlung der Fehlerlichtbögen weisen Brandschutzschalter einen Spannungs- und/oder Stromsensor auf.

Aufgabe der vorliegenden Erfindung ist es, einen kompakten Schalter zum Schutz elektrischer Stromkreise mit verschiedenen Schutzfunktionen bereitzustellen, wobei zumindest ein Teil der Schutzfunktionen überprüft werden kann.

Diese Aufgabe wird durch einen Schalter mit den Merkmalen des Patentanspruch 1 gelöst.

Erfindungsgemäß ist vorgesehen, dass ein Schalter sowohl eine Erkennung hinsichtlich des Überschreitens bestimmter Stromgrenzwerte, insbesondere Differenzstromgrenzwerte, als auch des Vorliegens von Fehlerlichtbögen durchführt, und zwar insbesondere beide Funktionen mit Hilfe eines Mikroprozessors realisiert. Ferner erfolgt eine Überprüfung sowohl der Fehlerlichtbogenerkennung durch eine erfindungsgemäße Fehlerlichtbogensimulationseinheit als auch eine Überprüfung der Fehlerstromerkennung durch einen erfindungsgemäßen Summenstromwandler mit neuartiger Anschaltung, durch eine Verbindung einer zweiten Wicklung des Summenstromwandlers mit dem Mikroprozessor, beispielsweise über einen ersten Widerstand.

Dies hat den besonderen Vorteil, dass ein kompakter Schalter zum Schutz von elektrischen Stromkreisen gegeben ist, der ferner eine Überprüfung wesentlicher Schutzfunktionen bereitstellt.

Vorteilhafte Ausgestaltungen der Erfindung sind in den Unteransprüchen angegeben.

In einer vorteilhaften Ausgestaltung der Erfindung ist der Mikroprozessor derart ausgestaltet, dass bei oder nach Betätigung der Testtaste der Mikroprozessor in einen Testmodus wechselt, ein Testsignal vom Mikroprozessor an die Fehlerlichtbogensimulationseinheit gegeben wird, die Fehlerlichbogensimulationseinheit an ihren Ausgängen für eine erste Zeitdauer je ein Fehlerlichtbogensimulationssignal abgibt und dieses an Stelle der Stromwerte oder/und Spannungswerte dem Mikroprozessor zugeführt wird und der Mikroprozessor das Vorliegen eines Fehlerlichtbogens prüft.

Dies hat den besonderen Vorteil, dass eine Überprüfung der Fehlerlichtbogenerkennung im Mikroprozessor durch Erzeugung typischer Strom- oder/und Spannungssignale für den Fehlerlichtbogenfall durch eine Fehlerlichtbogensimulationseinheit, wobei die Signale an Stelle ermittelter Strom- oder/und Spannungswerte des elektrischen Stromkreises für eine kurze Testperiode dem Mikroprozessor zugeführt werden. So lässt sich ein bequemer Test durchführen. Ferner lässt sich eine solche Fehlerlichtbogensimulationseinheit sehr kompakt realisieren, beispielsweise durch einen Application Specific Integrated Circuit oder in einem solchen.

In einer vorteilhaften Ausgestaltung der Erfindung ist der Mikroprozessor derart ausgestaltet, dass bei oder nach Betätigung der Testtaste der Mikroprozessor in einen Testmodus wechselt, der Mikroprozessor über den ersten Widerstand zur zweiten Wicklung für eine zweite Zeitdauer einen Teststrom abgibt und der Mikroprozessor das Vorliegen der Überschreitung eines Differenzstromgrenzwertes prüft.

Dies hat den besonderen Vorteil, dass eine einfache und elegante Prüfung hinsichtlich des Vorliegens der Fehlerstromfunktionalität gegeben ist. Der Ausgang eines Mikroprozessors, beispielsweiser ein digitaler Ausgang, prägt direkt seinen Pegel, insbesondere High-Pegel, als Strom in den Summenstromwandler ein, beispielsweise definiert durch den ersten Widerstand. Der magnetische Fluss muss durch die erste Wicklung, die Differenzströme erkennt, erkannt werden und im fehlerfreien Fall zu einer simulierten Auslösung führen.

In einer vorteilhaften Ausgestaltung der Erfindung ist der Mikroprozessor derart ausgestaltet, dass die Fehlerlichtbogenprüfung gemäß Patentanspruch 2 und die Differenzstromprüfung gemäß Patentanspruch 3 nacheinander durchgeführt werden und dass nach positiven Abschluss beider Prüfungen eine Auslösung des Schalters erfolgt, andernfalls keine Auslösung erfolgt. Wobei die Prüfungen in beliebiger Reihenfolge stattfinden können.

Dies hat den besonderen Vorteil, dass eine kombinierte Prüfroutine gegeben ist, so dass durch ein Prüfsignal zwei Funktionen geprüft werden.

In einer vorteilhaften Ausgestaltung der Erfindung ist zwischen Stromsensor und Mikroprozessor eine Stromverarbeitungseinheit vorgesehen.

Dies hat den besonderen Vorteil, dass eine Aufbereitung, Filterung oder/und Umwandlung der Stromwerte in mikroprozessorgeeignetere Formen erfolgen kann.

In einer vorteilhaften Ausgestaltung der Erfindung ist zwischen Spannungssensor und Mikroprozessor eine Spannungsverarbeitungseinheit vorgesehen.

Dies hat den besonderen Vorteil, dass eine Aufbereitung, Filterung oder/und Umwandlung der Spannungswerte in mikroprozessorgeeignetere Formen erfolgen kann.

In einer vorteilhaften Ausgestaltung der Erfindung ist zwischen erster Wicklung des Summenstromwandlers und Mikroprozessor eine Differenzstromverarbeitungseinheit vorgesehen. Dies hat den besonderen Vorteil, dass eine Aufbereitung, Filterung oder/und Umwandlung der Differenzstromwerte in mikroprozessorgeeignetere Formen erfolgen kann.

In einer vorteilhaften Ausgestaltung der Erfindung folgt dem Stromsensor einen erste Umschalteinheit (SLF), die andererseits mit einem Ausgang der Fehlerlichtbogensimulationseinheit verbunden ist.

Dies hat den besonderen Vorteil, dass eine schnelle Umschaltung auf die Fehlerlichtbogensimulationseinheit ermöglicht wird.

In einer vorteilhaften Ausgestaltung der Erfindung folgt dem Spannungssensor einen zweite Umschalteinheit (SHF), die andererseits mit einem Ausgang der Fehlerlichtbogensimulationseinheit verbunden ist.

Dies hat den besonderen Vorteil, dass eine schnelle Umschaltung auf die Fehlerlichtbogensimulationseinheit ermöglicht wird.

In einer vorteilhaften Ausgestaltung der Erfindung sind die erste Umschalteinheit, die zweite Umschalteinheit, die Fehlerlichtbogensimulationseinheit, die Spannungsverarbeitungseinheit und die Stromverarbeitungseinheit in einem ASIC realisiert.

Dies hat den besonderen Vorteil, dass eine besonders kompakte Realisierung eines Schalters ermöglicht wird.

In einer vorteilhaften Ausgestaltung der Erfindung ist eine thermische Stromüberwachungseinheit vorgesehen. Mit thermischer Stromüberwachungseinheit ist eine für Leitungsschutzschalter vorgesehene Überwachungseinheit gemeint, die bei Überströmen, beispielsweise zeitverzögert, auslöst und beispielsweise durch einen Bimetallauslöser realisiert sein kann.

Dies hat den besonderen Vorteil, dass eine weitere Funktionalität im Schalter realisiert ist.

In einer vorteilhaften Ausgestaltung der Erfindung ist eine magnetische Stromüberwachungseinheit vorgesehen. Mit magnetischer Stromüberwachungseinheit ist eine für Leitungsschutzschalter vorgesehene Überwachungseinheit gemeint, die bei Überströmen, beispielsweise zeitnah, auslöst. Beispielsweise ist diese durch eine Art Magnetspule realisiert.

Dies hat den besonderen Vorteil, dass eine weitere Funktionalität im Schalter realisiert ist.

In einer vorteilhaften Ausgestaltung der Erfindung weist der Stromsensor einen Shunt-Widerstand auf.

Dies hat den besonderen Vorteil, dass eine besonders einfache Lösung für einen Stromsensor gegeben ist, mit dem eine kompakte Realisierung eines Schalters ermöglicht wird.

In einer vorteilhaften Ausgestaltung der Erfindung weist die erste oder zweite Umschalteinheit einen digitalen Schalter oder ein einstellbares Filter auf.

Dies hat den besonderen Vorteil, dass eine in einem Application Specific Intergrated Circuit, kurz ASIC, realisierbare Lösung gegeben ist, wodurch eine kompakte Realisierung eines erfindungsgemäßen Schalters möglich wird.

In einer vorteilhaften Ausgestaltung der Erfindung ist zwischen Mikroprozessor und zweiter Wicklung ein Digital-Analog Umsetzer vorgesehen.

Dies hat den besonderen Vorteil, dass ein Digitalsignal eines Mikroprozessors beispielsweise in ein Analog Signal gewandelt werden kann, so dass der Summenstromsensor beispielsweise mit einem sinusförmigen Teststrom beaufschlagt werden kann, wodurch sich ein realitätsnaherer Fehlerstromtest realisieren lässt.

In einer vorteilhaften Ausgestaltung der Erfindung, ist die erste Zeitdauer bzw. die Dauer dessen Testmodus kürzer als die definierte Auslösezeit für das Vorliegen eines Fehlerlichtbogens.

Dies hat den besonderen Vorteil, dass ein Fehlerlichtbogentest durchgeführt werden kann, ohne die Schutzüberwachung zu beeinträchtigen. D.h. während der Überwachung kann ein Test durchgeführt werden, da die Testzeit kürzer als die Auslösezeit für den entsprechenden Fehler ist.

In einer vorteilhaften Ausgestaltung der Erfindung, ist die zweite Zeitdauer bzw. die Dauer dessen Testmodus kürzer als die definierte Auslösezeit für die Überschreitung bestimmter Stromgrenzwerte.

Dies hat den besonderen Vorteil, dass ein Stromgrenzwerttest, insbesondere ein Differenzstromgrenzwerttest bzw. Fehlerstromtest, durchgeführt werden kann, ohne die Schutzüberwachung hinsichtlich beispielsweise Fehlerströme zu beeinträchtigen. D.h. während der Überwachung kann ein Test durchgeführt werden, da die Testzeit kürzer als die Auslösezeit für den entsprechenden Fehler ist.

Alle Ausgestaltungen, sowohl in abhängiger Form rückbezogen auf den unabhängigen Patentanspruch, als auch rückbezogen lediglich auf einzelne Merkmale oder Merkmalskombinationen von Patentansprüchen, bewirken eine Verbesserung eines Schalters.

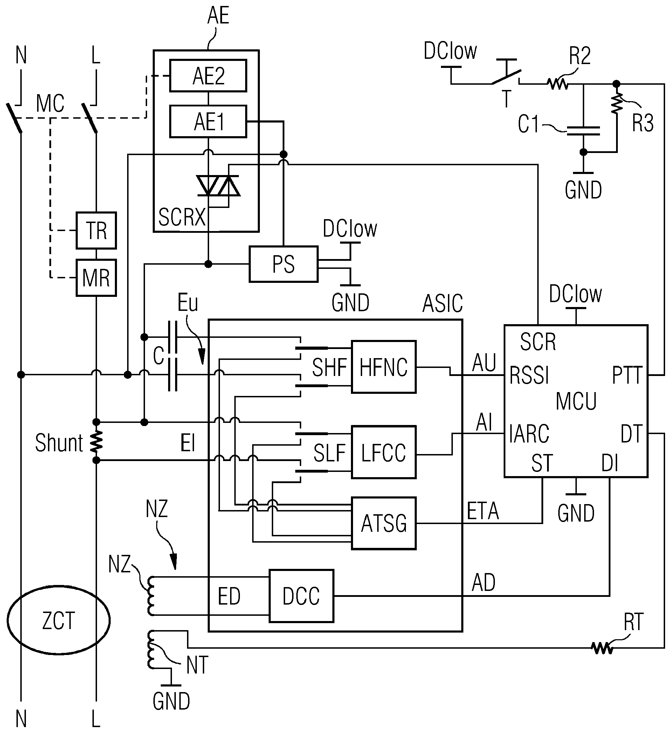

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung des Ausführungsbeispiels, die im Zusammenhang mit der Zeichnung näher erläutert werden.

Hierbei zeigt die:

Figur      ein prinzipielles Schaltbild eines erfindungsgemäßen Schalters.

Die Figur zeigt zwei Leiter N, L eines elektrischen Stromkreises. Die Leiter sind jeweils durch Kontakte MC trennbar. Die Kontakte MC können durch eine thermische Stromüberwachungseinheit TR geöffnet werden. Die Kontakte MC können durch eine magnetische Stromüberwachungseinheit MR geöffnet werden. Die Kontakte MC können durch eine Auslöseeinrichtung AE geöffnet werden, beispielsweise eine elektronische Auslöseeinrichtung mit einem Halbleiterbauelement SCRX, sowie ersten und zweiten Auslöseteileinheiten AE1, AE2, die beispielsweise eine Auslösemechanik AE2 oder eine Spule AE1 umfassen können.

Die Auslöseeinheit AE kann beispielsweise durch die Leiter N, L mit elektrischer Energie versorgt werden, wie dargestellt.

Die beiden Leiter N, L sind durch einen Summenstromwandler ZCT geführt, beispielsweise den Kern eines Summenstromwandlers. Der Summenstromwandler ZCT weist erfindungsgemäß eine erste Wicklung NZ und eine zweite Wicklung NT auf, beispielsweise auf dem Kern des Summenstromwandlers. Die erste Wicklung NZ dient zur Ermittlung von Differenzströmen bzw. Fehlerströmen im elektrischen Stromkreis der Leiter N, L. An der ersten Wicklung NZ kann ein Differenzstrom abgenommen werden. Die zweite Wicklung NT dient zum Testen bzw. zur Erzeugung eines testweisen Fehlerstromes im Summenstromwandler ZCT, wobei der Teststrom durch die erste Wicklung NZ erkannt werden soll.

Einer der beiden Leiter bzw. beide Leiter N, L weisen einen Stromsensor Shunt auf. Dieser kann beispielsweise als Widerstand, wie ein Shunt-Widerstand, Übertrager/Transformator oder Rogowskispule realisiert sein. Ferner ist ein Spannungssensor vorgesehen, der beispielsweise lediglich durch Abgriffe an beiden Leitern N, L realisiert sein kann.

Ein Netzteil PS ist vorgesehen, dass mit den beiden Leitern N, L des elektrischen Stromkreises verbunden ist. Es stellt eine Versorgungsspannung DClow, Gnd zur Verfügung, beispielsweise eine Gleichspannung im Bereich von 0 bis 5 Volt. Ein Pol der Versorgungsspannung, beispielsweise Gnd, kann mit dem Gehäuseanschluss bzw. Masse des Schalters verbunden sein.

Ein Mikroprozessor MCU ist vorgesehen, der mit dem Netzteil PS verbunden ist und die Versorgungsspannung DClow, Gnd erhält. Dieser weist mehrere Eingänge auf, unter anderem einen Eingang zur Differenzstromerkennung DI, einen Eingang RSSI zur Spannungsauswertung, einen Eingang IARC zur Stromauswertung und einen Eingang PTT für eine Testtaste T. Ferner weist dieser mehrere Ausgänge auf, unter anderem einen Ausgang ST für ein Testsignal zur Erzeugung eines Fehlerlichtbogensimulationssignales, ein Ausgang DT zur Abgabe eines Teststromes, einen Ausgang SCR zur Abgabe eines Auslösesignales an die Auslöseeinrichtung AE zur Unterbrechung des elektrischen Stromkreises.

Ein Applikations spezifischer Schaltkreis bzw. Application Specific Integrated Circuit ASIC ist vorgesehen, der mehrere Eingänge aufweist, unter anderem einen Eingang EU für die Spannung des elektrischen Stromkreises, einen Eingang EI für den Strom des elektrischen Stromkreises, einen Eingang ED für den Differenzstrom des elektrischen Stromkreises und einen Eingang ETA für ein Testsignal zur Erzeugung mindestens eines Fehlerlichtbogensimulationssignales aufweist. Weiterhin sind mehrere Ausgänge vorgesehen, unter anderem ein Ausgang AU zur Abgabe von Spannungswerten, ein Ausgang AI zur Abgabe von Stromwerten und ein Ausgang AD zur Abgabe von Differenzstromwerten.

Der Eingang PTT für eine Testtaste T des Mikroprozessors MCU ist mit einer Serienschaltung eines zweiten Widerstandes R2 und einer Testtaste T verbunden, die andererseits mit einem Anschluss der Versorgungsspannung DClow oder Gnd des Netzteiles PS verbunden ist. Parallel zur Serienschaltung, am mikroprozessorseitigen Anschluss, kann ein erster Kondensator C1 oder/und ein dritter Widerstand R3 mit dem anderen Anschluss der Versorgungsspannung Gnd oder DClow des Netzteiles geschaltet sein.

Der Ausgang DT für den Teststrom des Mikroprozessors MCU ist entweder direkt oder über einen ersten Widerstand RT mit der zweiten Wicklung NT des Summenstromwandlers ZCT verbunden. Gibt der Mikroprozessor an seinem Ausgang DT einen Teststrom ab, beispielsweise durch eine Änderung des Pegels, fließt ein Teststrom durch die zweite Wicklung NT, wodurch ein Fehlerstrom simuliert wird.

Der Ausgang SCR für ein Auslösesignal des Mikroprozessors MCU ist mit der Auslöseeinrichtung AE verbunden, so dass ein Auslösesignal den elektrischen Stromkreis mittels der Auslöseeinrichtung AE und der Kontakte MC unterbricht.

Der Ausgang ST des Mikroprozessors MCU ist mit dem Eingang ETA des ASIC verbunden.

Der Ausgang AU des ASIC ist mit dem Eingang RSSI des Mikroprozessors MCU verbunden.

Der Ausgang AI des ASIC ist mit dem Eingang IARC des Mikroprozessors MCU verbunden.

Die erste Wicklung NZ, die einen Differenz- bzw. Fehlerstrom abgibt, ist mit dem Eingang ED des ASIC verbunden, wobei der Ausgang AD des ASIC mit dem Eingang DI des Mikroprozessors MCU verbunden ist. Im ASIC kann zwischen Eingang ED und Ausgang AD eine dritte Signalaufbereitungseinheit bzw. Differenzstromverarbeitungseinheit DCC vorgesehen sein. Dies kann beispielsweise den Fehlerstrom der ersten Wicklung NZ in eine definierte elektrische Spannung wandeln. Ferner kann eine Filterung, Verstärkung oder/und Offseteinstellung erfolgen.

Der Eingang EI des ASIC ist mit dem Stromsensor Shunt verbunden. Der Eingang EU ist mit dem Spannungssensor verbunden, beispielsweise ist der Eingang EU direkt oder über Kondensatoren bzw. ein Hochpassfilter C mit Spannungsabgriffen der Leiter L, N des elektrischen Stromkreises verbunden. Die Kondensatoren bzw. das Hochpassfilter haben den Vorteil, dass insbesondere hohe Frequenzen detektiert werden können.

Ermittelte Stromwerte des Stromsensors Shunt werden über den Eingang EI dem ASIC zugeführt. Diese gelangen über eine erste Umschalteinheit SLF und den Ausgang AI zum Eingang IARC des Mikroprozessors MCU. Zwischen erster Umschalteinheit SLF und Ausgang AI kann eine erste Signalaufbereitungseinheit bzw. Stromverarbeitungseinheit LFCC vorgesehen sein. Dies kann beispielsweise die Stromwerte des Stromsensors Shunt in eine definierte elektrische Spannung wandeln. Ferner kann eine Filterung, Verstärkung oder/und Offseteinstellung erfolgen.

In analoger Weise ist der Eingang EU des ASIC intern mit einer zweiten Umschalteinheit SHF verbunden, die wiederum direkt oder über eine zweite Signalaufbereitungseinheit bzw. Spannungsverarbeitungseinheit HFNC mit dem Ausgang AU verbunden ist. Diese kann beispielsweise die Spannungswerte in eine definierte zweite elektrische Spannung wandeln. Ferner kann eine Filterung, Verstärkung oder/und Offseteinstellung erfolgen.

Die erste und zweite Umschalteinheit SLF, SHF sind wiederum mit je einem Ausgang einer Fehlerlichtbogensimulationseinheit ATSG verbunden. Dessen Eingang ist mit dem Eingang ETA des ASIC verbunden.

Die erste und zweite Umschalteinheit SLF, SHF können beispielsweise als Kontaktumschaltung mittels ein/mehrerer Relais realisiert sein, durch Halbleiterschalter, digitale Schalter, durch jeweilige parallelgeschaltete Filter, deren Durchlassverhalten gesteuert wird, etc.

Der Ausgang ST des Mikroprozessors MCU ist mit dem Eingang ETA des ASIC verbunden, so dass ein Testsignal des Mikroprozessors MCU den ASIC veranlasst ein Fehlerlichtbogensimulationssignal durch die Fehlerlichtbogensimulationseinheit ATSG zu erzeugen, dass an Stelle der Spannung oder/und des Stromes des elektrischen Stromkreises, beispielsweise im ASIC selbst, beispielsweise durch eine Umschaltung der ersten oder/und zweiten Umschalteinheit SLF, SHF, die durch den Eingang ETA bzw. die Fehlerlichtbogensimulationseinheit ATSG gesteuert sein kann, den Eingängen IARC, RSSI des Mikroprozessors MCU zugeführt wird, beispielsweise ebenfalls über die erste oder/und zweite Signalaufbereitungseinheit LFCC, HFNC.

Im Folgenden soll die Funktionsweise näher erläutert werden.

Der Schalter verfügt über Kontakte MC, die geöffnet werden können, um eine Last von einer Energiequelle zu trennen. Ein Netzteil PS versorgt den Schalter bzw. dessen Einheiten mit einer Spannung, beispielsweise 3,3 Volt Gleichspannung.

Der Mikroprozessor MCU führt verschiedene Funktionen aus. Unter anderem eine Fehlerlichtbogenerkennungsfunktion, wobei mit den zugeführten Spannungs- und Stromwerten bzw. deren Äquivalente / gewandelte oder aufbereite Werte ein Fehlerlichtbogenerkennung im Mikroprozessor durchgeführt wird. Wird ein Fehlerlichtbogen erkannt, wird am Ausgang SCR ein Auslösesignal an die Auslöseeinrichtung AE abgegeben, um den elektrischen Stromkreis zu unterbrechen.

Die Fehlerlichtbogenfunktion des Mikroprozessors kann beispielsweise eine Stromerfassung, beispielsweise im Niederfrequenzbereich (<1 kHz), durchführen, um einen Lichtbogen und/oder Laststrom zu erfassen. Ein Widerstand als Stromsensor Shunt ist ein bevorzugter Sensor, da er einen sehr begrenzten Raum benötigt. Der Spannungsabfall kann beispielsweise an einem Leiterteil gemessen werden. Über den Widerstand dieses Leiterteiles und dem Spannungsabfall kann der Strom berechnet werden. Alternativ kann ein Stromtransformator oder Hall-Sensor verwendet werden.

Das Signal des Stromsensors kann durch die erste Signalaufbereitungseinheit LFCC aufbereitet, wie gleichgerichtet, gefiltert, korrigiert oder/und verstärkt werden. Es wird dann dem Eingang IARC des Mikroprozessors MCU zugeführt, der es beispielsweise analog/digital umsetzten kann.

Die Spannungswerte können direkt oder über ein Hochpassfilter C, beispielsweise mittels in Serie geschalteter Kondensatoren, dem Eingang EU des ASIC zugeführt werden. Die Spannungswerte können durch eine zweite Signalaufbereitungseinheit HFNC in analoger Weise gleichgerichtet, gefiltert, korrigiert oder/und verstärkt werden. Es wird dann dem Eingang RSSI des Mikroprozessors MCU zugeführt, der es beispielsweise analog/digital umsetzten kann.

Die verschiedenen Signalaufbereitungseinheiten bzw. - schaltungen können in einem Application Specific Intergrated Circuit ASIC angeordnet sein, womit Platz gespart wird.

Die Erkennung von Fehler- bzw. Störlichtbögen auf der Grundlage von Spannungs- und Stromwerten ist bekannt. Diese Funktion wird im Mikroprozessor MCU durchgeführt.

Die Fehlerstrom-Überwachung des Schalters wird mit dem Summenstromwandler ZCT realisiert. Bei Erdschluss induziert der Differenzstrom eine Spannung in der ersten Wicklung NZ. Dieses Fehlerstrom der ersten Wicklung bzw. dieses Signal dem Eingang DI des Mikroprozessor MCU zugeführt. Alternativ kann es vorher durch die dritte Signalaufbereitungseinheit DCC, die beispielsweise im ASIC angeordnet ist, indem beispielsweise die erste Wicklung NZ mit dem Eingang ED des ASIC verbunden ist, dessen Ausgang AD mit dem Eingang DI des Mikroprozessors MCU verbunden ist, aufbereitet werden, in dem es gefiltert, korrigiert oder/und verstärkt wird. Der Eingang DI des Mikroprozessors MCU kann eine analog/digital Umsetzung durchführen.

Eine Fehlerstrom-Funktion des Mikroprozessors überwacht den ermittelten Fehlerstrom, vergleicht ihn mit (Fehlerstrom-)Grenzwerten und bei Überschreitung erfolgt über ein Auslösesignal des Ausganges SCR eine Unterbrechung des Stromkreises durch die Auslöseeinheit AE bzw. die Kontakte MC.

Üblicherweise erfolgt eine Auslösung, wenn der Differenzstrom zwischen 50% und 100% der Nennfehlerstromes ist. Der bevorzugte Wert ist 75%.

Die Erkennung von Störlichtbögen und Differenzströmen wird durch ein oder mehrere Programme im Mikroprozessor MCU durchgeführt.

Eine erfindungsgemäße Überprüfung der Funktionen des Schalters kann wie folgt erfolgen:

Eine Testtaste T wird verwendet, um dem Mikroprozessor MCU zu signalisieren, dass ein Testverfahren gestartet werden soll. Durch Drücken der Testtaste T wird die Spannung DClow beispielsweise mittels eines Netzwerk von zweiten und dritten Widerständen R2, R3 und einem ersten Kondensator C1 mit dem Eingang PTT verbunden, wodurch dieser einen hohen Pegel erhält. Wenn die Testtaste T nicht gedrückt ist, erzwingt der dritte Widerstand R3 oder ein Mikroprozessor interner Widerstand einen niedrigen Pegel.

Der erste Kondensator C1 kann Kontaktprellen bzw. dessen Auswirkungen vermeiden.

Nach Drücken der Testtaste T bzw. hohem Pegel am Eingang PTT startet der Mikroprozessor MCU ein Testverfahren. Alternativ können auch niedrige Pegel verwendet werden. Dieses Testverfahren kann einen oder zwei Schritte aufweisen.

Der Mikroprozessor MCU gibt ein Testsignal an zur Erzeugung eines Fehlerlichtbogensimulationssignales über seinen Ausgang ST an den Eingang ETA des ASIC, dessen Fehlerlichtbogensimulationseinheit ATSG Fehlerlichtbogensimulationssignale erzeugt, die über die erste oder/und zweite Umschalteinheit SLF, SHF zum Mikroprozessor MCU gelangen. Die Umschalteinheiten werden bei einem Testsignale entsprechend mitgesteuert. Die Fehlerlichtbogensimulationssignale können auch die erste oder/und zweite Signalaufbereitungseinheit LFCC, HFNC durchlaufen, ehe sie vom Ausgang AI, AU des ASIC zum Eingang IARC, RSSI des Mikroprozessors gelangen.

Wenn das Testverfahren nicht abläuft, erhält der Mikroprozessor MCU die Strom- bzw. Spannungswerte bzw. deren aufbereitete Äquivalente an seinen Eingängen IARC, RSSI.

Wenn das Testverfahren läuft werden die Strom- und Spannungssensoren getrennt und beispielsweise die Signalaufbereitungseinheiten LFCC, HFNC, sind mit der Fehlerlichtbogensimulationseinheit ATSG verbunden. Die Fehlerlichtbogensimulationseinheit ATSG erzeugt synthetische Spannungs- bzw. Stromwerte bzw. Signale, die die Präsenz eines Fehlerlichtbogens im elektrischen Stromkreis bzw. Lastkreis simuliert. Der Mikroprozessor MCU muss diesen simulierten Fehlerllichtbogen erkennen. Da der Mikroprozessor in diesen Fall im speziellen Testmodus bzw. Testverfahren ist, wird nach Erkennung des Fehlerlichtbogens eine Auslösung / Unterbrechung des elektrischen Stromkreises durch geführt. Erfolgt keine Erkennung im Testmodus, erfolgt keine Auslösung / Unterbrechung. Alternativ kann nach dem Fehlerlichtbogen-Testprogramm auch keine Auslösung / Unterbrechung erfolgen und ein zweites Testprogramm zur Fehlerstromüberprüfung oder anderen Prüfung durchgeführt werden.

Das Fehlerlichtbogentestprogramm wird dazu vorher beendet.

Das Fehlerstromtestprogramm erfolgt wie folgt. Der Mikroprozessor MCU gibt einen Teststrom durch seinen (digitalen) Ausgang DT ab. Dieser Ausgang DT ist mit der zweiten Wicklung NT verbunden, gegebenenfalls über einen ersten Widerstand RT. Der Ausgang DT kann beispielsweise nur den Zustand niedriger oder hoher Pegel annehmen, er kann so beispielsweise ein Rechtecksignal erzeugen. Beispielsweise kann so ein Rechtecksignal mit einer Frequenz erzeigt werden, die der des elektrischen Stromkreises entspricht. Hat dieser eine Frequenz von beispielsweise 50 Hz, so wird ein Rechtecksignal mit ebenfalls 50 Hz erzeugt.

Alternativ kann ein Digital-Analog-Umsetzer verwendet werden, mit dem ein Sinussignal mit der entsprechenden Frequenz erzeugt werden kann.

Bei einem Digitalausgang mit niedrigen Pegel 0 Volt und hohem Pegel $V_{DC}$ Volt, hat der Teststrom einen Wert von:

$$\hat{i} = \frac{NT \cdot V_{DC}}{RT}$$

NT - Windungszahl der zweiten Wicklung
$V_{DC}$ - Spannungspegel des Ausgangs DT
RT - Widerstand in Ohm des ersten Widerstandes RT

Der Effektivwert $i_{RMS}$ des Rechtecksignals ist:

$$i_{RMS} = \frac{\hat{i}}{\sqrt{2}} = \frac{NT \cdot V_{DC}}{\sqrt{2} \cdot RT}$$

Das Verhältnis erster Widerstand RT als Funktion des Teststromes und der Spannung ist:

$$\frac{NT}{RT} = \frac{\sqrt{2} \cdot i_{RMS}}{V_{DC}}$$

Die Norm EN 61009-1 verlangt, dass der Teststrom nicht 166% des maximalen Fehlerstromes I∆n überschreitet, bei Fehlerströmen von I∆n ≤30mA, sowie von 250% des I∆n für I∆n> 30mA. Für einen 30mA Fehlerstromschutzschalter bzw. einer Fehlerstromfunktion im erfindungsgemäßen Schalter somit bei 5/3. Eine erste Bedingung ist somit:

$$\frac{NT}{RT} \leq \frac{5}{3} \cdot i_{\Delta n} \cdot \frac{\sqrt{2}}{V_{DC}}$$

Ferner muss die Fehlerfunktion einen Teststrom erkennen, der größer als die Nachweissschwelle (z.B. 75% I∆n) ist. Somit ergibt sich als zweite Bedingung:

$$\frac{NT}{RT} \geq \frac{3}{4} \cdot i_{\Delta n} \cdot \frac{\sqrt{2}}{V_{DC}}$$

Es muss berücksichtigt werden, dass die Erfassung des Differenzstromes eine relative Toleranz α aufweist. So muss der Wert des Verhältnisses NT/RT mit Korrekturfaktor (1+α) multipliziert werden. Man erhält:

$$\frac{NT}{RT} \geq \frac{3}{4} \cdot i_{\Delta n} \cdot \frac{\sqrt{2}}{V_{DC}} \cdot (1 + \alpha)$$

Schließlich muss die Anzahl der Testwicklungen und der Wert des ersten Widerstandes RT folgende Bedingungen für eine 30mA Fehlerstromschutzfunktion erfüllen:

$$\frac{3 \cdot i_{\Delta n} \cdot (1 + \alpha)}{2 \cdot \sqrt{2} \cdot V_{DC}} < \frac{NT}{RT} < \frac{5 \cdot \sqrt{2} \cdot i_{\Delta n}}{3 \cdot V_{DC}}$$

Der Teststrom enthält eine Gleichstromkomponente. Diese muss beim Summenstromwandler ZCT, insbesondere beim Kernmaterial berücksichtigt werden. Die Gleichstromkomponente hat den Wert von:

$$i_{DC} = \frac{\hat{i}}{2} = \frac{NT \cdot V_{DC}}{2 \cdot RT}$$

Dieser Strom führt zu einer zusätzlichen Gleichspannungs-Feldstärke, die dem Wechselfeld des Teststromes überlagert ist.

Wenn der Summenstromwandler einen Kern mit einer Hysterese vom Typ R oder Z aufweist, kann der Verlust signifikant sein und die transformierte Spannung an der ersten Wicklung NZ klein sein. Solche weichmagnetischen Materialien haben im Allgemeinen ein Verhältnis zwischen Remanenz und Sättigungspolarisation bei (Br/Bsat) von über 0,6. Das Kernmaterial muss eine ausreichend flache Hysterese aufweisen, um sicherzustellen, dass der Differenzstrom der zweiten Wicklung NT mit geringen Verlusten induziert wird.

Es ist vorteilhaft Kernmaterialen mit einer Hysterese vom Typ F zu verwenden. Das Verhältnis Br/Bs sollte so klein wie möglich sein (im Allgemeinen <0,3).

Die Verlustleistung während des Testens ist:

$$P = \frac{V_{DC}^{2}}{2 \cdot RT}$$

Der erste Widerstand RT muss die folgende Bedingung erfüllen, um nicht beschädigt zu werden:

$$RT \geq \frac{V_{DC}^{2}}{2 \cdot P_{RATED}}$$

Für eine Spannungsversorgung von VDC = 3,3 V ist der minimale Widerstandswert für einen 0402 Widerstand, der eine Nennleistung $P_{RATED}$ von 63 mW aufweist, beispielsweise bei 86,4 $\Omega$. Man erhält als mögliche Windungsanzahl der zweiten Wicklung NT bei einer Toleranz $\alpha$ = 10%:

$$0.92 < NT < 1.85 \quad \rightarrow \quad \mathtt{NT} \; = \; 1$$

Diese geringe Windungszahl kann leicht über den Kern des Summenstromwandlers gewickelt werden. Es sollte überprüft werden, dass der Strom am digitalen Ausgang des Mikroprozessors MCU nicht dessen Spezifikation überschreitet. Wenn dies der Fall ist, müssen die Werte von RT und NT entsprechend erhöht werden.

Der Teststrom wird für eine ausreichende Zeitdauer angelegt, die es dem Mikroprozessor MCU ermöglicht, den Wert des synthetischen Fehlerstromes zu ermitteln und mit dem (Fehlerstrome-)Grenzwert bzw. der Auslöseschwelle zu vergleichen.

Wenn dieser Fehlerstromtest erfolgreich verlaufen ist, wird durch den Mikroprozessor ein Auslösesignal an seinem Ausgang SCR abgegeben für eine Auslösung / Unterbrechung des elektrischen Stromkreises.

Beide Tests für den Fehlerlichtbogentest und Fehlerstromtest können einzeln oder nacheinander in beliebiger Reihenfolge durchgeführt werden. Bei zwei durchgeführten Tests erfolgt eine Auslösung nach Testende nur, wenn beide Tests erfolgreich abgeschlossen wurden.

Die Tests können eine echte Fehlersituation maskieren, d.h. während des Tests tritt tatsächlich ein Fehler im elektrischen Stromkreis auf.

Um auch für diesen Fall Sicherheit herzustellen, wird die jeweilige Testdauer immer kürzer als die maximal zulässige Auslösezeit für den Normalfall gewählt. Dadurch ist eine Auslösung innerhalb der zulässigen Auslösezeit gegeben.

Für einen Fehlerlichtbogentest kann eine erste Zeitdauer festgelegt werden. Diese erste Zeitdauer bzw. die Dauer dessen Testmodus ist vorteilhafterweise kürzer als die definierte Auslösezeit für das Vorliegen eines Fehlerlichtbogens.

Für einen Fehlerstromtest kann eine zweite Zeitdauer festgelegt werden. Diese zweite Zeitdauer bzw. die Dauer dessen Testmodus ist kürzer als die definierte Auslösezeit für die Überschreitung bestimmter Strom- bzw. Differenzstromgrenzwerte.

Wenn eine Schutzfunktion im Schalter beschädigt ist, so ist die Testsequenz für diesen Teil nicht erfolgreich. In diesem Fall darf das Gerät nicht auslösen, um auf diesen Umstand hinzuweisen.

Allerdings sollte der Schalter noch auslösen, wenn ein echter Fehler für die funktionsfähige Schutzfunktion vorliegt. Dies unabhängig vom Ergebnis der Prüfung der fehlerhaften Schutzfunktion.

Das Testverfahren erlaubt einen einzelnen oder nacheinander ablaufenden Test für eine Fehlerstrom- oder/und Fehlerlichtbogenprüfung eines Schalters bzw. der Schutzfunktion eines Schalters, insbesondere Brandschutzschalters, Fehlerstromschalters oder kombinierten Fehlerstrom/Brandschutzschalters. Mit einer einzigen Testtaste T kann ein Test initiiert werden. Dies direkt mit einem Mikroprozessor MCU. Eine Testsignalerzeugung für Fehlerlichtbogensignale kann in einem Application Specific Integrated Circuit ASIC erfolgen. Dies erlaubt eine Platz- und Kostensparende Realisierung.

Eine Test-Fehlerstromerzeugung kann einfach durch den Ausgang eines Mikroprozessors und gegebenenfalls einen ersten Widerstand erfolgen.

Die Kombination dieser Funktionen spart erheblich Platz und machen die Realisierung einer kompakten (Schutz-)Schalters für Fehlerströme und Fehlerlichtbögen, zum Beispiel in einem Modul mit 18 mm Breite, möglich.

Die Erfindung macht die Verwendung eine üblichen Testschaltung für Fehlerstromschalter überflüssig, bei der üblicherweise ein Prüfschalter verwendet wird, der die Spannung des elektrischen Stromkreises über einen Prüfwiderstand auf eine Testwicklung des Summenstromwandlers legt. Durch Schließen des Prüfschalters fließt ein Wechselstrom durch den Prüfwiderstand und die Prüfwicklung. Da die Netzspannung direkt verwendet wird, ist der Stromkreis entsprechend auszulegen, d.h. der Prüfschalter und der Testwiderstand muss die Netzspannung (Isolation in geöffnetem Zustand) aushalten. Ferner muss der Testwiderstand eine entsprechende Verlustleistung aufweisen.

Ferner muss der Testwiderstand die Verlustleistung für eine viel längere Dauer aushalten, weil viele Benutzer versuchen bei defektem Schalter die Prüftaste länger zu drücken, um eine Auslösung zu erreichen.

Mit der Erfindung ist die Realisierung eines Kombinations-Schalters, der Brandschutz-, Fehlerstrom- und gegebenenfalls Leitungsschutzfunktionen (Überstromschutz, Kurzschlussschutz) in einem kompakten Design ermöglicht, was neu ist.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

AD       Ausgang Differenzstromwerte
AE       Auslöseeinrichtung
AE1     Erste Auslöseteileinheit, Spule
AE2     Zweite Auslöseteileinheit, Auslösemechanik
AI        Ausgang Stromwerte

ASIC      Applikations spezifischer Schaltkreis
ATSG     Fehlerlichtbogensimulationseinheit
AU        Ausgang Spannungswerte
C          Hochpassfilter
C1         Erster Kondensator
DCC      Dritte Signalaufbereitungseinheit / Differenzstromverarbeitungseinheit
DClow    Versorgungsspannung
DI         Eingang Differenzstromerkennung
DT        Ausgang Teststrom
ED        Eingang Differenzstrom
EI         Eingang Strom Stromkreis
ETA       Eingang Testsignal Erzeugung Fehlerlichtbogensimulationssignal
EU        Eingang Spannung Stromkreis
GND      Versorgungsspannung
HFNC     Zweite Signalaufbereitungseinheit / Spannungsverarbeitungseinheit
IARC      Eingang Stromauswertung
L          Leiter L
LFCC     Erste Signalaufbereitungseinheit / Stromverarbeitungseinheit
MC        Kontakte
MCU      Mikroprozessor
MR        Magnetische Stromüberwachungseinheit
N          Leiter N
NT        Zweite Wicklung, Testweiser Fehlerstrom
NZ        Erste Wicklung, Differenzströme, Fehlerströme
PS        Netzteil
PTT       Eingang Testtaste
RSSI      Eingang Spannungsauswertung
RT        Erster Widerstand
R2        Zweiter Widerstand
R3        Dritter Widerstand
SCR       Ausgang Auslösesignal
SCRX     Halbleiterbauelement, Triac, Thyristor
SHF       Zweite Umschalteinheit
Shunt     Stromsensor
SLF       Erste Umschalteinheit
ST        Ausgang Erzeugung Testsignal
T          Testtaste
TR        Thermische Stromüberwachungseinheit
ZCT      Summenstromwandler

**Patentansprüche**

1. Schalter zum Schutz eines elektrischen Stromkreises,

    - mit einer Auslöseeinrichtung (AE) zur Unterbrechung des elektrischen Stromkreises,
    - mit einem Summenstromwandler (ZCT), durch den Leiter (N, L) des elektrischen Stromkreises zur Ermittlung von Differenzströmen geführt sind und der eine erste Wicklung (NZ) aufweist, an der ein Differenzstrom abnehmbar ist,
    - mit einem Stromsensor (Shunt) zur Ermittlung von Stromwerten des elektrischen Stromkreises,
    - mit einem Spannungssensor zur Ermittlung von Spannungswerten des elektrischen Stromkreises,
    - mit einer Testtaste (T),
    - mit einer Fehlerlichtbogensimulationseinheit (ATSG), die mindestens einen Eingang (ETA) und mindestens zwei Ausgänge aufweist,
    - mit einem Mikroprozessor (MCU), der mit der Testtaste (T), dem Stromsensor (Shunt), dem Spannungssensor, der ersten Wicklung des Summenstromwandler (NZ), dem Eingang der Fehlerlichtbogensimulationseinheit (ATSG) und der Auslöseeinrichtung (AE) verbunden ist, und derart ausgestaltet ist, dass bei Überschreitung eines bestimmten Strom- oder Differenzstromgrenzwertes oder bei Vorliegen eines Fehlerlichtbogens eine Unterbrechung des elektrischen Stromkreises durch die Auslöseeinrichtung (AE) erfolgt,

wobei der Summenstromwandler (ZCT) eine zweite Wicklung (NT) aufweist, die direkt oder über einen ersten Widerstand (RT) mit dem Mikroprozessor (MCU) verbunden ist,
wobei die Signale der Ausgänge der Fehlerlichtbogensimulationseinheit (ATSG) an Stelle der Strom- oder/und Spannungswerte dem Mikroprozessor (MCU) durch ein Testsignal zuführbar sind.

2. Schalter nach Patentanspruch 1,
**dadurch gekennzeichnet,**
**dass** der Mikroprozessor (MCU) derart ausgestaltet ist, dass bei oder nach Betätigung der Testtaste (T) der Mikroprozessor (MCU) in einen Testmodus wechselt,
ein Testsignal vom Mikroprozessor (MCU) an die Fehlerlichtbogensimulationseinheit (ATSG) gegeben wird,
die Fehlerlichbogensimulationseinheit (ATSG) an ihren Ausgängen für eine erste Zeitdauer je ein Fehlerlichtbogensimulationssignal abgibt und dieses an Stelle der Stromwerte oder/und Spannungswerte dem Mikroprozessor zugeführt wird und der Mikroprozessor das Vorliegen eines Fehlerlichtbogens prüft.

3. Schalter nach Patentanspruch 1,
**dadurch gekennzeichnet,**
**dass** der Mikroprozessor (MCU) derart ausgestaltet ist, dass bei oder nach Betätigung der Testtaste der Mikroprozessor (MCU) in einen Testmodus wechselt,
der Mikroprozessor (MCU) direkt oder über den ersten Widerstand (RT) zur zweiten Wicklung für eine zweite Zeitdauer einen Teststrom abgibt und der Mikroprozessor (MCU) das Vorliegen der Überschreitung eines Differenzstromgrenzwertes prüft.

4. Schalter nach Patentanspruch 2 oder 3,
**dadurch gekennzeichnet,**
**dass** der Mikroprozessor (MCU) derart ausgestaltet ist, die Fehlerlichtbogenprüfung gemäß Patentanspruch 2 und die Differenzstromprüfung gemäß Patentanspruch 3 nacheinander durchgeführt werden, dass nach positiven Abschluss beider Prüfungen eine Auslösung des Schalters erfolgt, andernfalls keine Auslösung erfolgt.

5. Schalter nach einem der vorhergehenden Patentansprüche,
**dadurch gekennzeichnet,**
**dass** zwischen Stromsensor (Shunt) und Mikroprozessor (MCU) eine erste Signalaufbereitungseinheit (LFCC) vorgesehen ist.

6. Schalter nach einem der vorhergehenden Patentansprüche,
**dadurch gekennzeichnet,**
**dass** zwischen Spannungssensor und Mikroprozessor (MCU) eine zweite Signalaufbereitungseinheit (HFNC) vorgesehen ist.

7. Schalter nach einem der vorhergehenden Patentansprüche,
**dadurch gekennzeichnet,**
**dass** zwischen erster Wicklung (NZ) des Summenstromwandlers (ZCT) und Mikroprozessor (MCU) eine dritte Signalaufbereitungseinheit (DCC) vorgesehen ist.

8. Schalter nach einem der vorhergehenden Patentansprüche,
**dadurch gekennzeichnet,**
**dass** dem Stromsensor (Shunt) einen erste Umschalteinheit (SLF) folgt, die andererseits mit einem Ausgang der Fehlerlichtbogensimulationseinheit (ATSG) verbunden ist.

9. Schalter nach einem der vorhergehenden Patentansprüche,
**dadurch gekennzeichnet,**
**dass** dem Spannungssensor einen zweite Umschalteinheit (SHF) folgt, die andererseits mit einem Ausgang der Fehlerlichtbogensimulationseinheit (ATSG) verbunden ist.

10. Schalter nach einem der vorhergehenden Patentansprüche,
**dadurch gekennzeichnet,**
**dass** die erste Umschalteinheit (SLF), die zweite Umschalteinheit (SHF), die Fehlerlichtbogensimulationseinheit (ATSG), die Spannungsverarbeitungseinheit (HFNC) und die Stromverarbeitungseinheit (LFNC) in einem Applikations spezifischen Schaltkreis (ASIC) realisiert sind.

11. Schalter nach einem der vorhergehenden Patentansprüche,
**dadurch gekennzeichnet,**
**dass** eine thermische Stromüberwachungseinheit (TR) vorgesehen ist.

12. Schalter nach einem der vorhergehenden Patentansprüche,
**dadurch gekennzeichnet,**
**dass** eine magnetische Stromüberwachungseinheit (MR) vorgesehen ist.

13. Schalter nach einem der vorhergehenden Patentansprüche,
**dadurch gekennzeichnet,**
**dass** der Stromsensor (Shunt) einen Shunt-Widerstand aufweist.

14. Schalter nach einem der vorhergehenden Patentansprüche,
**dadurch gekennzeichnet,**
**dass** der Spannungssensor ein Hochpass-Filter (C) aufweist.

15. Schalter nach einem der vorhergehenden Patentansprüche,
**dadurch gekennzeichnet,**
**dass** die erste oder zweite Umschalteinheit (SLF, SHF) einen digitalen Schalter oder ein einstellbares Filter aufweist.

16. Schalter nach einem der vorhergehenden Patentansprüche,
**dadurch gekennzeichnet,**
**dass** zwischen Mikroprozessor (MCU) und zweiter Wicklung (NT) ein Digital-Analog Umsetzer vorgesehen ist.

17. Schalter nach einem der vorhergehenden Patentansprüche,
**dadurch gekennzeichnet,**
**dass** die erste Zeitdauer bzw. die Dauer dessen Testmodus kürzer als die definierte Auslösezeit für das Vorliegen eines Fehlerlichtbogens ist.

18. Schalter nach einem der vorhergehenden Patentansprüche,
**dadurch gekennzeichnet,**
**dass** die zweite Zeitdauer bzw. die Dauer dessen Testmodus kürzer als die definierte Auslösezeit für die Überschreitung bestimmter Strom- oder Differenzstromgrenzwerte ist.

**Europäisches Patentamt**
**European Patent Office**
**Office européen des brevets**

# EUROPÄISCHER RECHERCHENBERICHT

Nummer der Anmeldung

EP 17 18 1338

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | US 2007/208520 A1 (ZHANG BIN [US] ET AL) 6. September 2007 (2007-09-06) * das ganze Dokument * ----- | 1-18 | INV. H02H3/33 G01R31/327 |
| Y | US 2014/254050 A1 (HAINES JOSHUA PAUL [US] ET AL) 11. September 2014 (2014-09-11) * Absätze [0088] - [0010]; Abbildung 1 * ----- | 1-18 | ADD. H02H1/00 |
| A | US 2009/086387 A1 (ENGEL JOSEPH C [US]) 2. April 2009 (2009-04-02) * das ganze Dokument * ----- | 1-18 | |

**RECHERCHIERTE SACHGEBIETE (IPC)**

H02H
G01R

Der vorliegende Recherchenbericht wurde für alle Patentansprüche erstellt

| Recherchenort | Abschlußdatum der Recherche | Prüfer |
|---|---|---|
| München | 6. März 2018 | Trifonov, Antoniy |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

&  : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 17 18 1338

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-03-2018

| Im Recherchenbericht angeführtes Patentdokument | Datum der Veröffentlichung | Mitglied(er) der Patentfamilie | Datum der Veröffentlichung |
|---|---|---|---|
| US 2007208520 A1 | 06-09-2007 | CA 2644378 A1<br>CN 101395777 A<br>EP 1989771 A1<br>US 2007208520 A1<br>WO 2007106253 A1 | 20-09-2007<br>25-03-2009<br>12-11-2008<br>06-09-2007<br>20-09-2007 |
| US 2014254050 A1 | 11-09-2014 | KEINE | |
| US 2009086387 A1 | 02-04-2009 | CA 2639864 A1<br>US 2009086387 A1 | 27-03-2009<br>02-04-2009 |

EPO FORM P0461

Für nähere Einzelheiten zu diesem Anhang : siehe Amtsblatt des Europäischen Patentamts, Nr.12/82